# EUROPEAN PATENT SPECIFICATION

(11) **EP 1 466 512 B1**
(45) Date of publication and mention of the grant of the patent: **14.05.2008**
(21) Application number: 03703893.2
(22) Date of filing: 16.01.2003
(51) Int. Cl.: H05K 7/14

(54) **A LEVER THAT COMBINES INSERTION, RETENTION, AND EJECTION FUNCTIONS FOR CARDS**
HEBEL ZUM EINSCHIEBEN, ARRETIEREN UND HERAUSZIEHEN VON SCHALTUNGSKARTEN
UN MODELE NOUVEAU DE LEVIER POUR LA COMBINAISON DES FONCTIONS D'INSERTION, DE MAINTIEN, D'EJECTION DE MODULES POUR CARTES ADDITIONNELLES

(30) Priority: 18.01.2002 US 54083
(43) Date of publication of application: 13.10.2004
(73) Proprietor: Intel Corporation, Santa Clara, CA 95052 (US)
(72) Inventor: LING, Yun, Portland, OR 97229 (US); TONG, Daniel, Beaverton, OR 97006 (US)
(74) Representative: Goddar, Heinz J.
(86) International application number: PCT/US2003/001575
(87) International publication number: WO 2003/063566

(56) References cited:
- AT-B- 306 137
- US-A- 5 634 803

## Description

### FIELD OF THE INVENTION

The present invention relates to card edge connectors generally.

### BACKGROUND OF THE INVENTION

Card edge connectors are included on many of the printed circuit boards used in desktop and server computer systems. Card edge connectors accommodate add-on system components, such as modems, Ethernet hardware, memory repositories, wireless modems, EPS receivers, and other digital and electrical devices.
US 5634803 discloses a card-edge connector assembly comprising a connector having a slot therein to receive an edge portion of a card having one side that includes a first contact surface on the connector and a pair of corresponding latch/eject members. Each latch/eject member includes a locking portion horizontally extending at the top end with a lever portion obliquely upward extending opposite to the locking portion. The lever of the latch/eject member serves for ejecting the card from the slot.

Traditional design approaches have produced a slot balanced along its length by two opposing planar surfaces. A card having a n especially designed trace-covered edge, is inserted into the slot by positioning the trace-covered edge of the card over the slot, then pressing sharply downward on one or more portions of the card's top edge simultaneously. This action deflects the contact springs inside the slot and forces the card into the slot. The card is removed by grasping the sides or side edges of the card and lifting.

Because the shallow contact inside the slot grasps only a couple of millimeters or so of the bottom edge of the card, various connector designs have included metal or plastic clips at the ends of the slot to secure a card inserted into the slot. The bottom portion of a typical clip includes an ejector knob, which is positioned within the ends of the slot so that the card pushed into the slot will contact the ejector at each end of the slot and push it down. Pushing the ejectors down causes the upper portion of the clips, which is angled away from the ends of the connector, to rotate upwards to a vertical position. In the vertical position, the upper portions of the clips lockably engage notches cut in the side edges of the card. In this manner, the inserted card is secured in the connector for shipping.

However, those clips are passive devices. The clips do nothing to reduce the amount of user force required to insert the card into the slot. A common complaint among assembly line workers is that the amount of user force required to insert cards into card-edge connectors is excessive. This force, which varies proportionately to the pin count, is typically on the order of approximately 30 lbs for a 184-pin RIMM connector. Driven by higher bandwidth requirements, future card-edge connectors are heading toward higher pin counts on the order of 200 pin count, 300 pin count, and beyond. Naturally, the user force increases as pin count increases, and a solution is provided as described in the detailed description which follows.

### BRIEF DESCRIPTION OF THE DRAWINGS

The present invention is illustrated by way of example and not limitation in the figures of the accompanying drawings, in which:

**FIG. 1** is a front perspective view of a connector and memory card, according to one embodiment of the invention;

**FIG. 2** is a side view of one embodiment of a lever connector assembly showing both levers in a first opened position;

**FIG. 3** is a partial perspective view of one embodiment of a lever and connector assembly showing the lever in a first opened position;

**FIG. 4** is a cross-sectional partial front perspective view of a card edge connector assembly showing a lever locked in a second closed position;

**FIG. 5** is a cross-sectional partial front perspective view of a card-edge connector assembly showing placement of a lever within a case attached to an end of the connector;

**FIG. 6** is a front perspective view of one embodiment of a lever;

**FIG. 7** is a rear perspective view of one embodiment of a lever; and

**FIG. 8** is a flow chart of one embodiment of a method useable with the present invention.

### DETAILED DESCRIPTION

An apparatus and method useable with card edge connectors are disclosed. In the following detailed description, numerous specific details are set forth in order to provide a thorough understanding of the present invention. However, it will be apparent to one of ordinary skill in the art that these specific details need not be used to practice the present invention. In other circumstances, well-known structures, materials, or processes have not been shown or described in detail in order not to unnecessarily obscure the p resent invention.

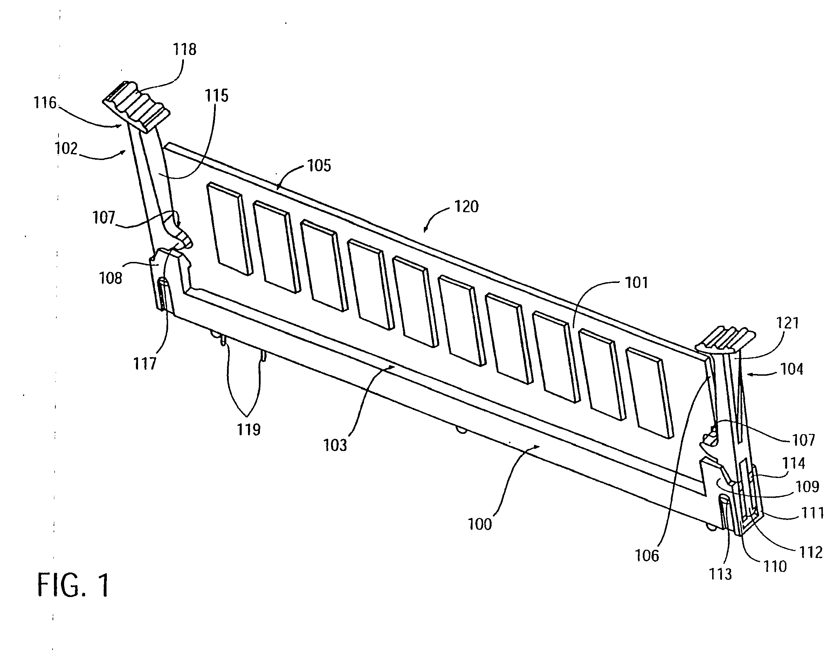

**FIG. 1** is a front perspective view of a lever connector assembly 120 having a connector 100 and a memory card 101, according to one embodiment of the invention. Connector 100 includes a slot 103 therein. The contact springs inside the connector slot 103 are not shown in the figure. The bottom edge of card 101 is removably inserted into slot 103 as shown. Levers (or lever mechanisms) 102 and 104 are rotatably attached to opposing ends of connector 101 and fixed in an upright position.

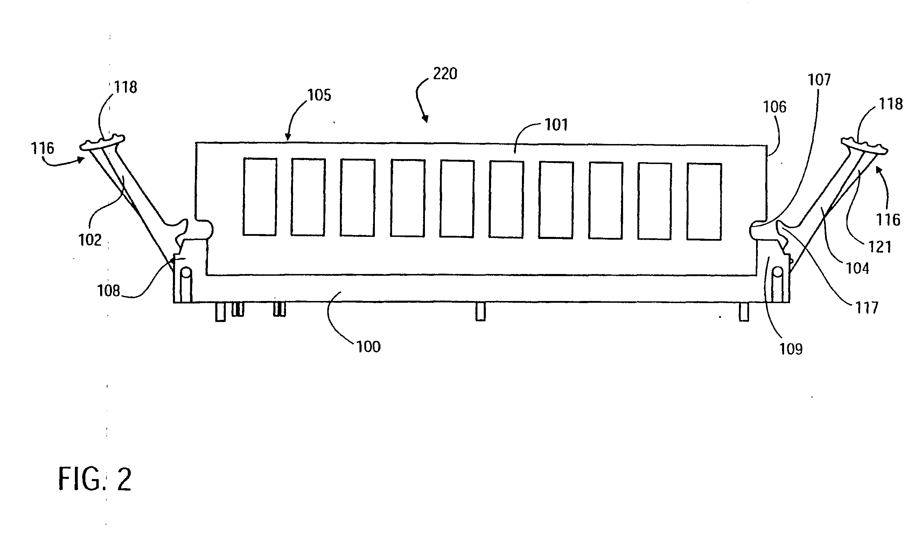

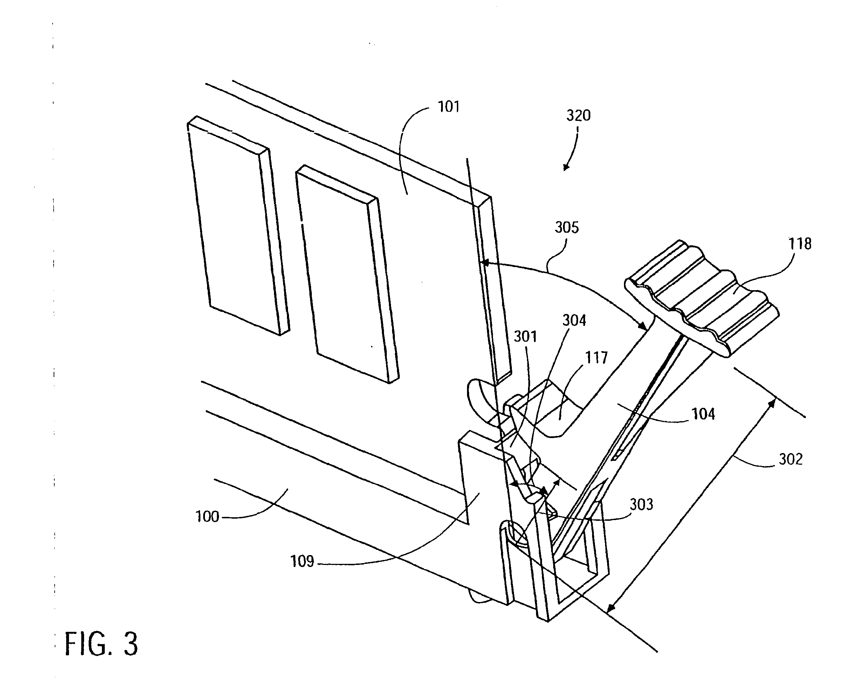

Card 101 is a memory card formed of a substrate having a thickness that allows card 101 to fit in slot 103, thereby making contact with the contact springs inside the slot. Card 101 includes a top edge 105 and at least one side 106 that includes a first contact surface 107. Top edge 105 is also referred to as a side opposing slot 103. Side 106 is referred to as a side not opposing slot 103, or as an edge portion 106. Illustratively, first contact surface 107 is a semicircular notch formed in side 106. It will be appreciated, however, that the shape of first contact surface 107 functions to move card 101 into slot 103 when levers 102 and 104 are moved from a first opened position (shown in FIGS. 2 and 3) to a second closed position shown in **FIG. 1**. Positioning first contact surface 107 in the lower one-third of side 106 maximizes the mechanical advantage afforded by lever 102 or lever 104.

Cases 108 and 109 are attached to the ends of connector 100. Cases 108 and 109 provide a way of pivotally securing levers 102 and 104, respectively, with the ends of connector 100. In one embodiment, cases 108 and 109 (hereinafter case 109) are formed of the same material (for example, plastics) as connector 100. Case 109 includes a first and second opposing planar surfaces 110 and 111, respectively. Planar surfaces 110 and 111 are positioned to define a channel therebetween, into which a base end 114 of lever 104 (or 102) is rotatably inserted. Each of planar surfaces 110 and 111 include an orifice 113 therein to receive a pivot (not shown) protruding from each side of lever 104 (and lever 102).

The channel formed in case 109 has a width that is slightly less than a width of uncompressed base end 114. Base end 114 of lever mechanism 102 includes a longitudinal channel 112 that permits base end 114 to deform near the pivots protruding from the sides of lever 104. This deformation allows base end 114 to be inserted within the channel formed in case 109. After insertion into case 109, base end 114 expands to insert the pivots attached to the sides of base end 114 into orifices 113.

With reference back to **FIG. 1**, an embodiment of levers 102 and 104 includes a middle portion 115, a first end 116, a contact surface 118, and an engaging surface 117. Engaging surface 117 is attached to the middle portion 115 of lever 102 or 104. Contact surface 118 is attached to the first end 116 of lever 102 or 104. A bottom portion of connector 100 includes one or more pins 119 to position connector 100 on a printed circuit board (not shown).

**FIG. 2** is a side view of one embodiment of a lever connector assembly 220 (which corresponds to lever connector assembly 120 of **FIG. 1**). In **FIG. 2** levers 102 and 104 are shown in a first position. In this position, contact surfaces 118, attached to the first ends 116 of levers 102 and 104, are tilted away from the sides 106 of card 101. Card 101 is positioned with its bottom edge (not shown) approximately at the opening of slot 103 (**FIG. 1**), and resting on, or near an ejector (not shown) attached to the base end 114 of each of levers 102 and 104.

In use, a user positions his or her hands outside the ends of connector 100, with the palms facing levers 102 and 104. The hands are then moved inwards towards connector 100 until the thumbs rest either on top surface 105 of card 101 or on contact surfaces 118 of lever 102 and lever 104. The index and middle fingers of each hand may rest against support ribs 121.

Increasing lateral pressure moves levers 102 and 104 upwards toward sides 106. The engaging surfaces 117 are protuberances extending from the lower middle portions of levers 102 and 103 that join with the first contact surfaces 107 to move card 101 into slot 103 (**FIG. 1**). During this operation, contact surfaces 118 move a greater distance than engaging surfaces 117 move towards the connector 100. In this manner, the engaging surfaces 117 may exert a force greater than the user force applied to contact surfaces 118. In one embodiment, engaging surfaces 117 may mate with first contact surfaces 107 to move card 101 into slot 103. Card 101 is removed by pushing or pulling contact surface 118 downward; this causes the ejectors (not shown) attached to the base ends of levers 102 and 104 to move upwards. The ejectors contact the bottom edge of card 101 and force it upwards out of slot 103 so that card 101 is easily removed and/or replaced.

**FIG. 3** is a partial front perspective view of card-edge connector assembly 320, which corresponds to card-edge connector assemblies 120 and 220 (as shown in **FIG. 3**). Lever 104 is movably coupled with case 109, which is attached to connector 100. A stop member 301 is included to limit the forward range of movement of lever 104.

As mentioned previously, contact surface 118 travels a distance 305, which is greater than a distance 304 traveled by engaging surface 117. Additionally, a length 302 is greater than a length 303. The ratio of length 302 to 303 is called the lever ratio and, in one embodiment, is approximately 3.5:1. The lever ratio determines the force-saving factor (mechanical advantage). The preferred ratio of 3.5:1 is obtained using a total lever height of approximately 1.75 inches. The total lever height is measured when lever 104 is in a closed (vertical) position from a top edge of a printed circuit board attached to connector 100 to a bottom surface of contact surface 118. With a ratio of 3.5:1, applying approximately 6 to 8 pounds of lateral user force to levers 102 and 104 may provide approximately 30.0 - 40.0 pounds of lever force, which is sufficient to move card 101 into slot 103 (**FIG. 1**). As shown, contact surface 118 is used to move lever 104 back and forth within the channel formed in case 109.

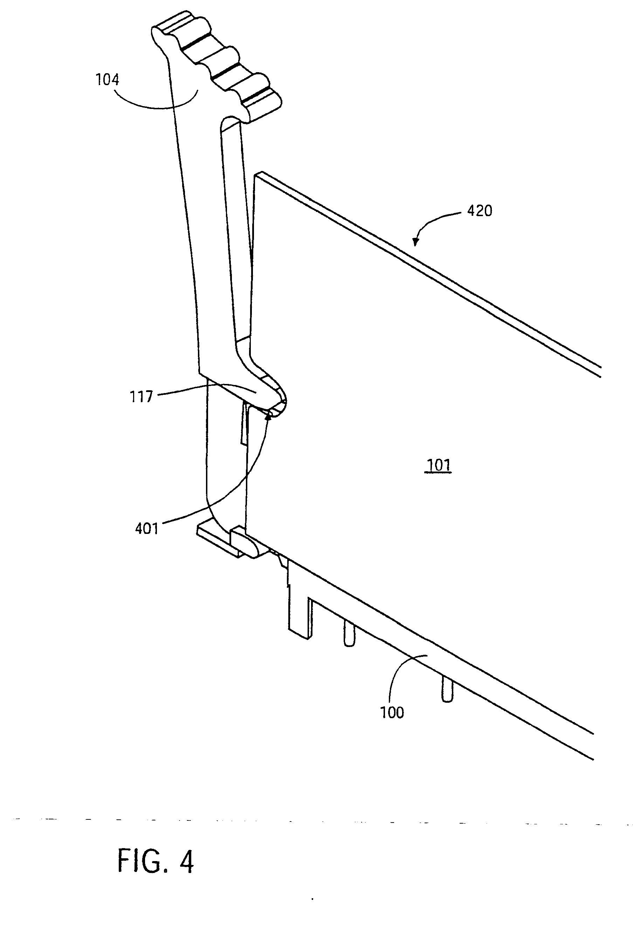

**FIG. 4** is a partial front perspective view of a card-edge connector assembly 420 (which corresponds to card-edge assemblies 120, 220 and 320) showing lever 104 locked in a closed (vertical) position. The protuberance, which is engaging surface 117, includes a curved frontal surface 401 that helps move card 101 down into connector 100. At the closed position shown in **FIG. 4**, engaging surface 117 retains card 101 in connector 100, and prevents card 101 from popping out of connector 100 during shipping and handling.

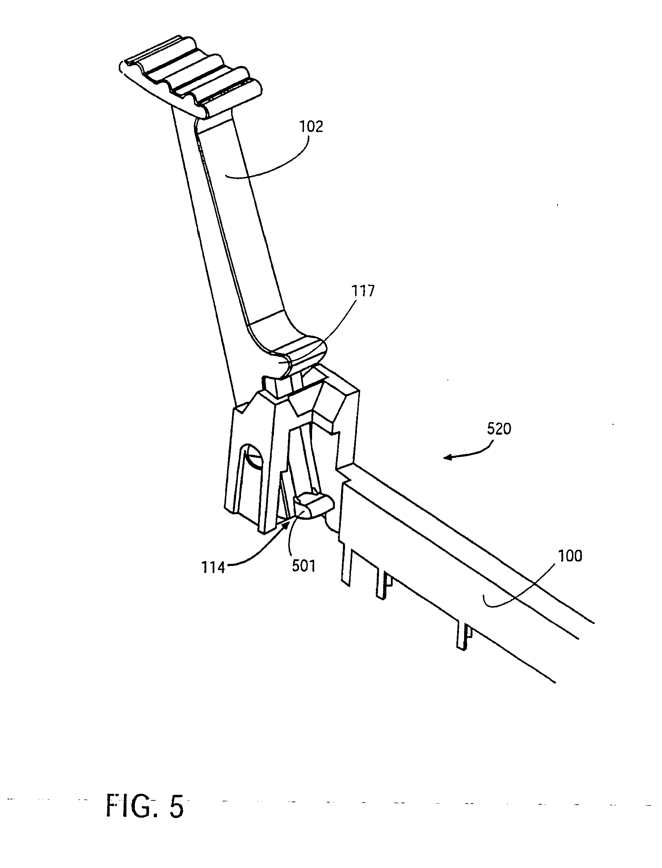

**FIG. 5** is a partial cutaway perspective view of card-edge connector assembly 520 (which corresponds to the card-edge assemblies 120-420 previously described). As shown in **FIG. 5**, lever 102 (and lever 104) may include an ejector 501, which is a protuberance attached to base end 114 of lever 102, below engaging surface 117. When lever 102 is in the open position (shown in **FIG. 5**), the base end 114 and ejector 501 are totally upwards within connector 100. As lever 102 is moved to a closed (upright) position, the base end 114 and ejector 501 are tilted downwards, and towards the exterior of the end of connector 101. The downward movement of ejector 501 allows a card (not shown) to slide into connector 101. Similarly, the upward movement of ejector 501 pushes the card upward out of connector 100.

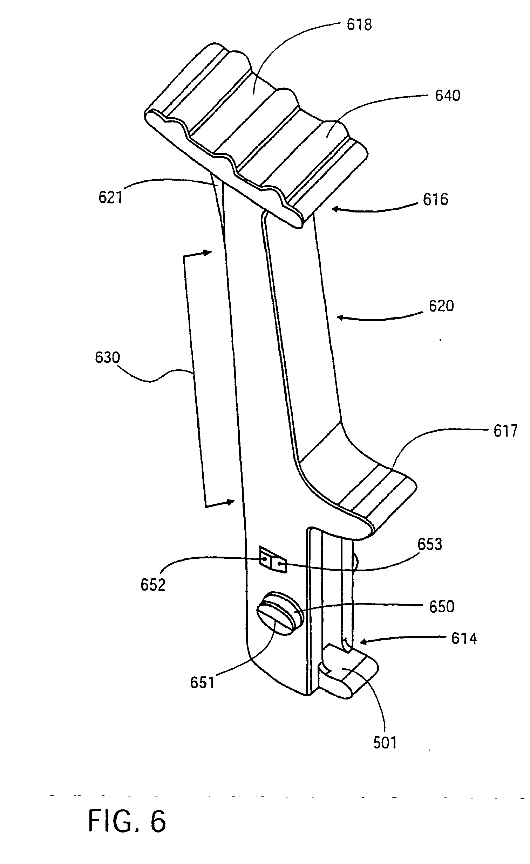

**FIG. 6** is a front perspective view of a lever 620, according to one embodiment of the invention. Contact surface 618 attached to first end 616 of level 620 functions as a gripping surface useful to move lever 620 between a first position and a second position. Rib 640 is included on the top surface of contact surface 618 to provide a more secure gripping surface. Support rib 621 may attach at one end to a bottom surface of contact surface 618 and along a length thereof to a back surface of lever 620 to provide improved structural support.

The lower region of middle portion 630 includes engaging member 617 corresponding to a first contact surface (not shown) formed in the memory card. Base end 614 includes a pivot 650 having an oblique surface 651. The bottom portion 651 of pivot 650 is oblique to permit downward insertion of base end 614 into a case (not shown) attached to a connector (not shown). Ejector 501 is attached to the lower portion of base end 614 to provide a way of lifting a card out of a connector (not shown).

The levers 102 and 104 are equipped with locks 652 (as shown in **FIG. 6**) to fix levers 102 and 104 in the upright closed position shown in **FIG. 1**. Locks 652 is small protuberances attached to a side of the base ends 114 of levers 102 and 104 that snap within corresponding grooves formed in planar surfaces 110 and 111 (**FIG. 1**). Lock 652 is attached to one or both side surfaces of lever 620. Oblique surface 653 permits lock 652 to slidably fit within the groove mentioned above. In one embodiment, lock 652 audibly clicks into place.

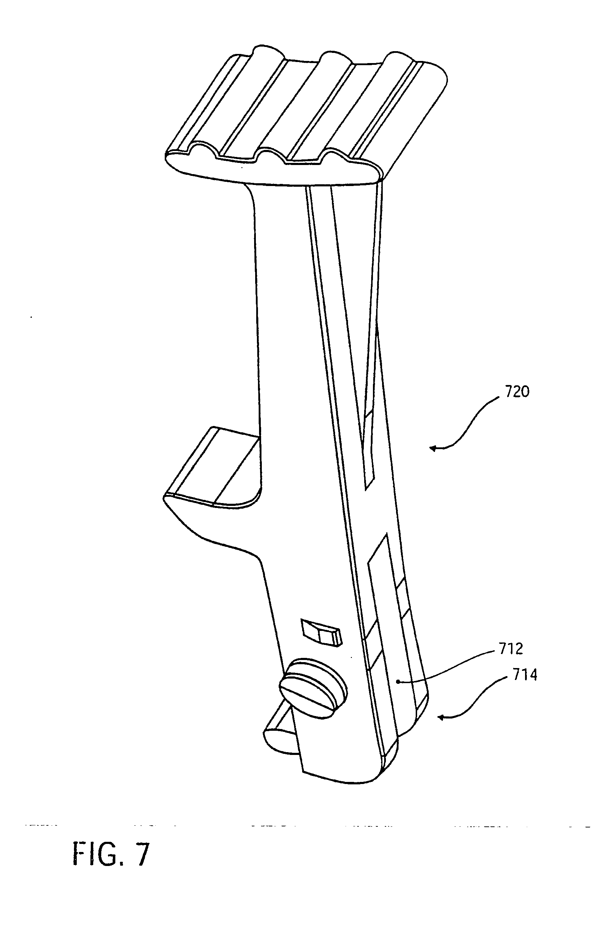

**FIG. 7** is a rear perspective view of a lever 720, which corresponds to lever 620 shown in **FIG. 6**. Lever 720 includes a slot 712 (corresponding to slot 112 in **FIG. 1**), which functions to allow the sides of base end 714 to be deformed, so that base end 714 may be inserted into a connector (not shown).

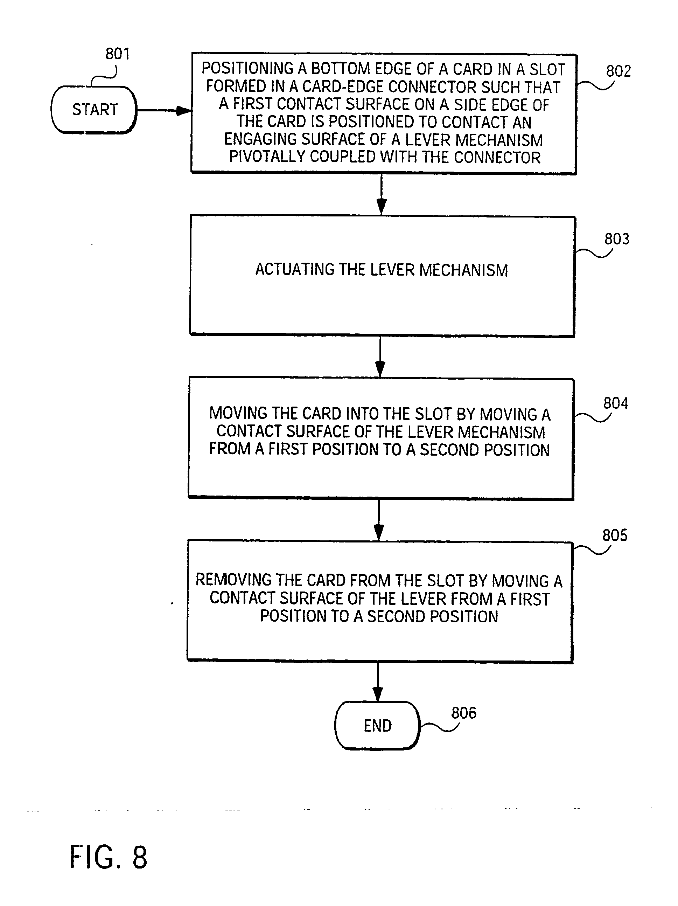

**FIG. 8** is a flowchart illustrating one embodiment of a method useable with the present invention. The method begins (801) by positioning (802) a bottom edge of a card in a slot formed in a card-edge connector. The connector may have a slot therein to receive a memory card, and the connector may include a lever mechanism attached to each end thereof. Each lever of each lever mechanism may include a contact surface and an engaging surface. In one embodiment, the contact surface is a generally planar gripping surface attached to a first end of each lever. The engaging surface is a protuberance attached to a lower middle portion of each lever. The card is positioned in the slot such that a first contact surface on a side edge of the card is positioned to contact the engaging surface of a lever mechanism pivotally coupled with the connector.

Next, the lever mechanism is actuated (803). In one embodiment, actuating the lever mechanism involves moving (804) the card into the slot by moving a contact surface of the lever associated with each lever mechanism from a first position to a second position. The contact surfaces attached to one end of the lever are moved towards the card by applying a user force to the contact surfaces. During movement, the lever's engaging surfaces join the card's first contact surfaces to move the card into the slot.

The card is removed (805) from the slot by moving a first contact surface of the lever(s) from a first position to a second position. The method ends at step 806.

Thus, a method and apparatus useable with card-edge connectors are disclosed. Although the present invention is described herein with reference to a specific preferred embodiment, many modifications and variations therein will readily occur to those with ordinary skill in the art. Accordingly, all such variations and modifications are included within the intended scope of the present invention as defined by the following claims.

## Claims

1. A card-edge connector assembly (120; 220; 320; 420; 520), comprising:
a connector (100) having a slot (103) therein to receive an edge portion of a card (101) having at least one side (106) that includes a first contact surface (107) on the connector (100); and
a lever mechanism (102; 104) movably coupled to the connector (100) and having a contact surface (118; 618) for contact by a person, the contact surface (118; 618) being moveable between a first position and a second position by the person, and an engaging surface (117) contacting a contact surface (107) on the card (101), the engaging surface being in a first position when the contact surface (118; 618) is in the first position and moving into a second position closer to the connector (100) upon movement of the contact surface (118; 618) from the first position to the second position, a distance (305) between the first and second positions of the contact surface (304) being larger than a distance (304) between the first and second positions of the engaging surface (117), wherein
the lever mechanism is a lever (102 or 104) pivotally coupled with the connector (100) via a pivot positioned near a base end of the lever (102 or 104),
the contact surface (118; 618) is attached to a first end of the lever (102 or 104), the engaging surface (117) extends from the lower middle portion of the lever (102 or 104) and the engaging surface (117) mates with the contact surface (107) to move the card (101) into the slot (103).

2. The assembly (120; 220; 320; 420; 520) of claim 1, wherein the first contact surface (117) is a notch.

3. The assembly (120; 220; 320; 420; 520) of claim 1, wherein the engaging surface (117) is a protuberance.

4. The assembly (120; 220; 320; 420; 520) of claim 1, wherein the card (101) is a memory card (101).

5. The assembly (120; 220; 320; 420; 520) of claim 1, further comprising:
an ejector (501) attached to a base end of the lever to remove from the slot (103) the card (101) inserted therein when the lever (102 or 104) is moved from the second closed position to the first open position.

6. The assembly (120; 220; 320; 420; 520) of claim 1, further comprising:
a locking mechanism (652) coupled with a lever (102 or 104) to lock the lever (102 or 104) in the second closed position.

7. The assembly (120; 220; 320; 420; 520) of claim 6, wherein the locking mechanism emits an audible sound as it locks into place.

## Patentansprüche

1. Randsteckerleistenanordnung (120; 220; 320; 420; 520), umfassend:
eine Steckvorrichtung (100) mit einem Schlitz (103) zum Aufnehmen eines Randabschnitts einer Karte (101), die wenigstens eine Seite (106) mit einer ersten Kontaktfläche (107) an der Steckvorrichtung (100) aufweist; und
einen Hebelmechanismus (102; 104), der beweglich an die Steckvorrichtung (100) gekoppelt ist und eine Kontaktfläche (118; 618) aufweist, die dazu dient, von einer Person berührt zu werden, wobei die Kontaktfläche (118; 618) von der Person zwischen einer ersten Position und einer zweiten Position hin und her beweglich ist, und eine Einrastfläche (117), die in Kontakt mit einer Kontaktfläche (107) an der Karte (101) gelangt, wobei die Einrastfläche sich in einer ersten Position befindet, wenn die Kontaktfläche (118; 618) sich in der ersten Position befindet, und sich in eine zweite Position näher zur Steckvorrichtung (100) bewegt, wenn die Kontaktfläche (118; 618) aus der ersten Position in die zweite Position bewegt wird, wobei eine Strecke (305) zwischen der ersten und zweiten Position der Kontaktfläche (304) größer ist als eine Strecke (304) zwischen der ersten und zweiten Position der Einrastfläche (117), wobei
der Hebelmechanismus ein Hebel (102 oder 104) ist, der über einen Zapfen, der nahe einem Basisende des Hebels (102 oder 104) angeordnet ist, schwenkbar an die Steckvorrichtung (100) gekoppelt ist,
wobei die Kontaktfläche (118; 618) an einem ersten Ende des Hebels (102 oder 104) befestigt ist, wobei die Einrastfläche (117) sich von dem unteren Mittelabschnitt des Hebels (102 oder 104) aus erstreckt, und die Einrastfläche (117) sich mit der Kontaktfläche (107) verbindet, um so die Karte (101) in den Schlitz (103) zu bewegen.

2. Anordnung (120; 220; 320; 420; 520) nach Anspruch 1, wobei die erste Kontaktfläche (117) eine Aussparung ist.

3. Anordnung (120; 220; 320; 420; 520) nach Anspruch 1, wobei die Einrastfläche (117) ein Vorsprung ist.

4. Anordnung (120; 220; 320; 420; 520) nach Anspruch 1, wobei die Karte (101) eine Speicherkarte (101) ist.

5. Anordnung (120; 220; 320; 420; 520) nach Anspruch 1, ferner umfassend:
eine Ausgabevorrichtung (501), die am Basisende des Hebels befestigt ist, um die Karte (101), die in den Schlitz (103) eingeführt ist, aus diesem zu entfernen, wenn der Hebel (102 oder 104) aus der zweiten geschlossenen Position in die erste offene Position bewegt wird.

6. Anordnung (120; 220; 320; 420; 520) nach Anspruch 1, ferner umfassend:
einen Arretiermechanismus (652), der an einen Hebel (102 oder 104) gekoppelt ist, um den Hebel (102 oder 104) in der zweiten geschlossenen Position zu arretieren.

7. Anordnung (120; 220; 320; 420; 520) nach Anspruch 6, wobei der Arretiermechanismus einen hörbaren Ton abgibt, wenn er seine Arretierposition erreicht.

## Revendications

1. Ensemble connecteur de bord de carte (120 ; 220 ; 320 ; 420 ; 520), comportant :
- un connecteur (100) présentant une fente (103) en son sein pour recevoir une partie de bord d'une carte (101) présentant au moins un côté (106) qui comporte une première surface de contact (107) sur le connecteur (100) ; et
- un mécanisme à levier (102 ; 104) couplé, de façon à être déplaçable, au connecteur (100) et présentant une surface de contact (118 ; 618) pour un contact par une personne, la surface de contact (118 ; 618) étant déplaçable entre une première position et une seconde position par la personne, et une surface de mise en prise (117) entrant en contact avec une surface de contact (107) sur la carte (101), la surface de mise en prise étant dans une première position lorsque la surface de contact (118 ; 618) est dans la première position et se déplaçant vers une seconde position plus proche du connecteur (100) lors du déplacement de la surface de contact (118 ; 618) de la première position à la seconde position, une distance (305) entre les première et seconde positions de la surface de contact (304) étant supérieure à une distance (304) entre les première et seconde positions de la surface de mise en prise (117),
dans lequel
- le mécanisme à levier est un levier (102 ou 104) couplé de manière à pouvoir pivoter avec le connecteur (100) via un pivot positionné à proximité d'une extrémité de base du levier (102 ou 104),
- la surface de contact (118 ; 618) est fixée à une première extrémité du levier (102 ou 104), la surface de mise en prise (117) s'étend à partir de la partie centrale inférieure du levier (102 ou 104) et la surface de mise en prise (117) s'accouple avec la surface de contact (107) pour déplacer la carte (101) dans la fente (103).

2. Ensemble (120 ; 220 ; 320 ; 420 ; 520) selon la revendication 1, dans lequel la première surface de contact (117) est une encoche.

3. Ensemble (120 ; 220 ; 320 ; 420 ; 520) selon la revendication 1, dans lequel la surface de mise en prise (117) est une protubérance.

4. Ensemble (120 ; 220 ; 320 ; 420 ; 520) selon la revendication 1, dans lequel la carte (101) est une carte mémoire (101).

5. Ensemble (120 ; 220 ; 320 ; 420 ; 520) selon la revendication 1, comportant en outre un éjecteur (501) fixé à une extrémité de base du levier pour extraire de la fente (103) la carte (101) insérée dans celle-ci lorsque le levier (102 ou 104) est déplacé de la seconde position fermée à la première position ouverte.

6. Ensemble (120 ; 220 ; 320 ; 420 ; 520) selon la revendication 1, comportant en outre un mécanisme de verrouillage (652) couplé à un levier (102 ou 104) pour verrouiller le levier (102 ou 104) dans la seconde position fermée.

7. Ensemble (120 ; 220 ; 320 ; 420 ; 520) selon la revendication 6, dans lequel le mécanisme de verrouillage émet un son audible lorsqu'il se verrouille.
